# EUROPEAN PATENT APPLICATION

(11) **EP 4 566 805 A1**
(43) Date of publication of application: **11.06.2025**
(21) Application number: 23214080.6
(22) Date of filing: 04.12.2023
(51) Int. Cl.: B30B 11/20, B30B 15/02, G01R 33/00, G01R 33/02, G01D 5/14, G01R 33/07

(54) **DIE FOR A PELLET MILL AND METHOD FOR DIE IDENTIFICATION**

(71) Applicant: ANDRITZ Feed & Biofuel A/S, 6705 Esbjerg (DK)
(72) Inventor: NIELSEN, Simon, 6683 Fovling (DK); HOY, Karsten, 6700 Esbjerg (DK); BANK NIELSEN, Ole, 6710 Esbjerg (DK)
(74) Representative: Anzel, Andreas

(57) **Abstract**

The invention concerns a die (1) for a pellet mill (11) comprising openings (2) and is characterized in that the die (1) comprises die identification means (6) for inducing changes to a magnetic field of a sensor (7) providing the magnetic field. The invention also concerns a method for die identification in a pellet chamber (10). The invention allows for an automated and reliable identification of the die (1), without disturbance of the die operation.

## Description

The invention concerns a die for a pellet mill for producing pellets from a material, comprising openings, where the die is configured for the material to be pressed from an inside of the die through the openings to an outside of the die. The invention also concerns a method for die identification in a pellet chamber.

Pellet mills may be used for producing pellets from a material. Ring die pellet mills are an example for a pellet mill used in large scale applications. The material is introduced to the rotatable die of the pellet mill, where the material is pressed through the die by rollers and cut off on the outside of the rotating die by knifes. Pellet mills with flat dies, where the material is pressed in an axial direction through the die, are also in industrial use. Such flat die pellet mills comprise knives rotating around an axis of rotation on the outside of the die for cutting off the material
Typically the die is installed in a harsh and demanding environment. Die replacement is required when the die is worn out or when the size of pellets must change. To keep track of the wear of the die, it is essential to record for each respective die the time in operation. This can be done manually, but is cumbersome and prone to errors.

The goal of the invention is a die allowing a reliable and effective identification when in operation in the pellet mill. A further goal is a robust die identification that can handle the harsh and demanding environment of pellet mills, where there is no risk of losing the identification features of the die.

According to the invention this is achieved in that the die is made of a ferromagnetic material and the die comprises die identification means for inducing changes to a magnetic field of a sensor providing the magnetic field, where the die identification means consist of identification openings and / or identification pockets and the die identification means being configured for allowing identification of the die. Following the invention the die is made of a ferromagnetic material, which is essential in order to allow the die, respectively the identification means, to induce changes to a magnetic field of a sensor providing the magnetic field. Further the die comprises identification means, which consist of either identification openings and / or identification pockets. An opening shall be understood to connect an inside of the die with an outside of the die. An example for an identification opening is a hole or a slot connecting the inside of the die with a outside of the die. A pocket shall be understood to extend from the outside of the die to somewhere within the die, but not to extend up to the inside of the die. Again an example for an identification pocket may be a hole, like a blind drilled hole, or a slot, both not extending up to the inside. According to the invention, the die identification means being configured for allowing identification of the die, meaning that the identification means, i.e. the identification openings and / or identification pockets, are arranged such, that when the die and the magnetic field of the sensor being in relative rotational movement around the axis of rotation, the die induces changes to the magnetic field - as the die identification means rotate relative to and through the magnetic field provided by the sensor - making up for a signal allowing for identification of the die. The induced changes to the magnetic field may be a binary code, meaning that the single identification mean, i.e. the identification opening and / or identification pocket, induces a change to the magnetic field (corresponding to a "1" of the binary code), or the single identification mean is missing and therefore no change to the magnetic field being induced (corresponding to a "0" of the binary code). Such obtained binary code allows explicit identification of the die. The induced changes to the magnetic field may also follow a different code with a number system with different digits, as following the invention the identification means, i.e. the identification openings and / or identification pockets, may induce changes at different explicit levels. The die according to the invention is especially suitable for use in pellet mills for producing animal feed pellets, biofuel pellets or waste material pellets from the material.

In a particularly advantageous embodiment of the invention the die identification means have varying void volumes. When the die and the sensor are in relative rotational movement around the axis of rotation and the identification means inducing changes to the magnetic field as the die identification means rotate relative to and through the magnetic field provided by the sensor, the varying void volumes of the die identification means allow for inducing changes to the magnetic field at varying extent and respectively to effectively make up for a signal allowing for identification of the die. In order to induce changes to the magnetic field according to a binary code, the single identification mean will either have a first void volume or a second void volume, where the changes induced to the magnetic field by the first void volume will correspond to a "1" of the binary code, and where the changes induced to the magnetic field by the second void volume will correspond to a "0" of the binary code. In order to induce changes to the magnetic field according to a different code with a number system with different digits, the single identification mean will have an explicit void volume allowing to induce a change to the magnetic field at an explicit level, where such explicit change induced to the magnetic field by the explicit void volume will correspond to a "number" of the number system. The explicit numbers of the single identification means will then make up for the signal allowing for identification of the die. It is advantageous that either the first void volume, the second void volume or one of the explicit void volumes has a void volume of zero, the void volume being defined as an absolute void volume. A void volume of zero means that the respective die identification mean has no void volume, i.e. the respective identification mean is filled and corresponds essentially to the die without an opening or pocket. This effectively allows to reduce the effort to provide the die with the required identification openings and / or identification pockets.

It is also advantageous to provide the die identification means, especially the identification openings, with a varying geometry, such as cylindrical, chamfered cylindrical, conical, truncated cone, etc. Explicit variation of the geometry of the die identification means allows an effective variation of the void volume. For instance, providing first die identification means with a cylindrical geometry, implying a first void volume; and providing second die identification means with a different cylindrical, chamfered cylindrical, conical or truncated cone geometry, etc., implying a second void volume. Such explicit variations of the geometry can easily be accomplished and effectively provide varying void volumes and consequently induce varying changes to the magnetic field at explicit levels.

In an advantageous embodiment of the invention the die is devoid of permanent magnets for allowing identification of the die. According to the invention, for identification of the die, no permanent magnets are required in the die. The application of permanent magnets for allowing identification of the die is prone to miss identification, for instance if permanent magnets get lost as a consequence of operating the die in the typical harsh environment. Additionally, adding permanent magnets for allowing identification of the die is rather elaborate and more costly, when compared with the invention.

In another advantageous embodiment of the invention, the die identification means are configured as holes or slots. According to the invention the die identification means are configured as identification openings and / or identification pockets, where the identification openings and / or the identification pockets may either be configured as holes or slots. Holes or slots may be manufactured easily and allow for effectively inducing changes to the magnetic field of a sensor.

In a further advantageous embodiment of the invention the die identification means configured as identification pockets are located on the outside of the die. This allows the die identification mean being configured as identification pocket to effectively induce changes to the magnetic field, when the die being in relative rotational movement to the sensor.

In an advantageous embodiment of the invention the die is a cylindrical ring die, the die being rotatable around an axis of rotation, the inside being configured as a radial inside and the outside being configured as a radial outside, the openings and the die identification means configured as identification openings connect the radial inside of the die with the radial outside of the die through the ring. Such a ring, especially cylindrical ring, is ideally suited for a pellet mill used in large scale applications, where the material is introduced to the inside of the rotatable ring die and the material is pressed through the openings of the die by rollers and cut off on the outside of the rotating die by knives. The identification means configured as identification openings and connecting the radial inside of the die with the radial outside of the die through the ring provide on the one hand the inventive solution, i.e. allowing for identification of the die, and contribute on the other hand to the throughput of material through the die.

In a further advantageous embodiment of the invention the die is a flat die, the die being configured for the material to be pressed in an axial direction through the openings of the die, the openings and the die identification means configured as identification openings connecting the inside and the outside of the die. Such a flat die is also ideally suited for a pellet mill used in large scale applications, where the material is introduced to the inside of the flat die and the material is pressed through the openings of the flat die to the outside of the die, where an extrusion mean is configured to press the material through the holes. On the outside of the flat die the material is cut off by rotating knifes. The identification means configured as identification openings and connecting the inside of the die with the outside of the die through the flat die provide on the one hand the inventive solution, i.e. allowing for identification of the die, and contribute on the other hand to the throughput of material through the die.

In a particularly advantageous embodiment of the invention the die identification means are arranged in a circumferential direction of the die. When the die and the sensor are configured to be rotatable relative to each other around an axis of rotation, the die identification means arranged in a circumferential direction of the die are effectively arranged. For instance, in case of a ring die with the identification means arranged in a circumferential direction of the ring die, a sensor also arranged on the circumferential side of the die providing the magnetic field, is effectively arranged in relation to the die identification means, effectively inducing changes to the magnetic field when the die is rotated around the axis of rotation. For instance, in case of a flat die with the identification means arranged in a circumferential direction on the outside of the flat die, a sensor will effectively induce changes to the magnetic field when the sensor is rotated around the axis of rotation.

It is advantageous to equally space the die identification means in the circumferential direction. As the die and the sensor are configured to be rotatable relative to each other around the axis of rotation, the die comprising the die identification means inducing changes to the magnetic field as the die identification means rotate relative to and through the magnetic field provided by the sensor, such arrangement allowing for inducing changes to the magnetic field in equally spaced time steps, making up for a signal to be read on revolution of the die.

In a particularly advantageous embodiment a die identification system comprises a die according to the invention and a sensor, preferably a Hall sensor, an inductive sensor or similar, the sensor providing a magnetic field, the die and the sensor being configured to be rotatable relative to each other around an axis of rotation for allowing a relative rotational movement of the die and the magnetic field of the sensor for inducing changes to the magnetic field via the die identification means and the sensor being configured for detecting changes to the magnetic field. The sensor, preferably a Hall sensor, an inductive sensor or similar, provides a magnetic field, to which field changes are induced as the die with the die identification means and the sensor providing the magnetic field are in a relative rotational movement around the axis of rotation, the identification means relatively passing through the magnetic field. The changes to the magnetic field are detected by the sensor, for instance as variable electrical properties, which are evaluated for identification of the die. Such identification system can easily be set up and can easily be retrofitted to existing systems. It is clear that such die identification system is ideal for use in a pellet mill for producing pellets from a material.

In another particularly advantageous embodiment of the invention a pellet chamber for a pellet mill for producing pellets from a material, comprises the die identification system according to the invention, at least one extrusion mean being disposed on the inside of the die, where the at least one extrusion mean is configured to press the material from the inside of the die through the openings to the outside of the die, knives for cutting off the material, said knives being disposed on the outside of the die, where the sensor is disposed at the outside of the die and the sensor is configured to provide a magnetic field and to detect changes to the magnetic field induced by the die identification means and thereby allowing die identification.

In an equally advantageous embodiment of the invention a pellet mill for producing pellets from a material, comprises an inlet, feeding means, optional conditioning means and a pellet chamber according to the invention, the feeding means being configured to feed the material from the inlet to the optional conditioning means or to the pellet chamber, the optional conditioning means being configured to feed the material to the pellet chamber, where feeding of the material is especially done to the inside of the die. The pellet mill according to the invention allows easy and continous monitoring of the explicit die in operation, where each die can easily and excactly be assigned the hours in operation, which is advantageous especially when the dies are regularly changed for operation reasons and later on installed again. The same advantages apply for the pellet chamber according to the invention, where such pellet chamber can easily be retrofitted to existing systems. In the case of a ring die a preferred extrusion mean is a roller. In case of a flat die a preferred extrusion mean is a screw, i.e an extrusion screw, compression screw etc.

The invention also relates to a method for die identification in a pellet chamber, where the pellet chamber according to the invention is provided with the die identification system according the invention, the die and the magnetic field of the sensor being in relative rotational movement around the axis of rotation, the sensor providing the magnetic field, the die comprising the die identification means inducing changes to the magnetic field as the die identification means rotate relative to and through the magnetic field provided by the sensor, the sensor detecting for changes to the magnetic field and providing a signal for identification of the die. Such method for die identification based on the die identification system according to the invention allows reliable and safe identification of the die, especially when the die is operated in a harsh environment.

In a particularly advantageous embodiment of the method the die identification means induce changes to the magnetic field due to having varying void volumes. This allows for an effective identification of the die, where the die can easily be manufactured and withstands in harsh environments.

The invention will now be described by way of example with reference to the drawings.
Fig. 1 shows a pellet mill according to the prior art.
Fig. 2 shows a die according to the prior art.
Fig. 3 shows a die according to the invention.
Fig. 4 shows a die according to the invention, where only the identification means are shown.
Fig. 5 shows a signal as received from a die identification system according the invention with identification means with varying void volumes.

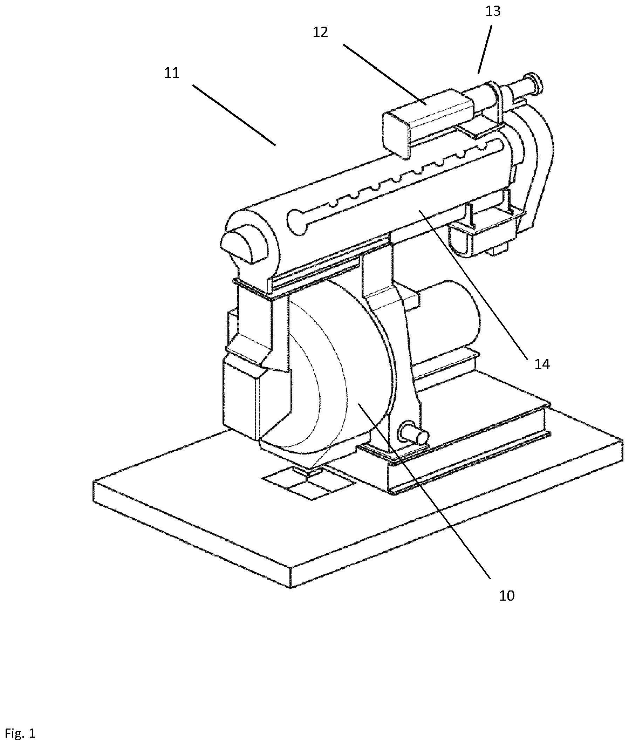

Fig. 1 shows a pellet mill according to the prior art. Such pellet mill 11 is suited for producing pellets from a material and comprises an inlet 12, feeding means 13, conditioning means 14 and a pellet chamber 10, the feeding means 13 being configured to feed the material from the inlet 12 to the conditioning means 14, the conditioning means 14 being configured to feed the material to the pellet chamber 10, where the material is fed to the inside 4 of the die 1. In Fig. 1 a ring die is implemented. Other configurations implementing a flat die in a pellet mill are also well known in the art. In Fig. 1 the pellet chamber 10 comprises at least one roller being disposed in the inside 4 of the die 1, where the at least one roller is configured to press the material from the inside 4 of the die 1 through the openings 2 to the outside 5 of the die 1, knives for cutting off the material, said knives being disposed on the outside 5 of the die 1.

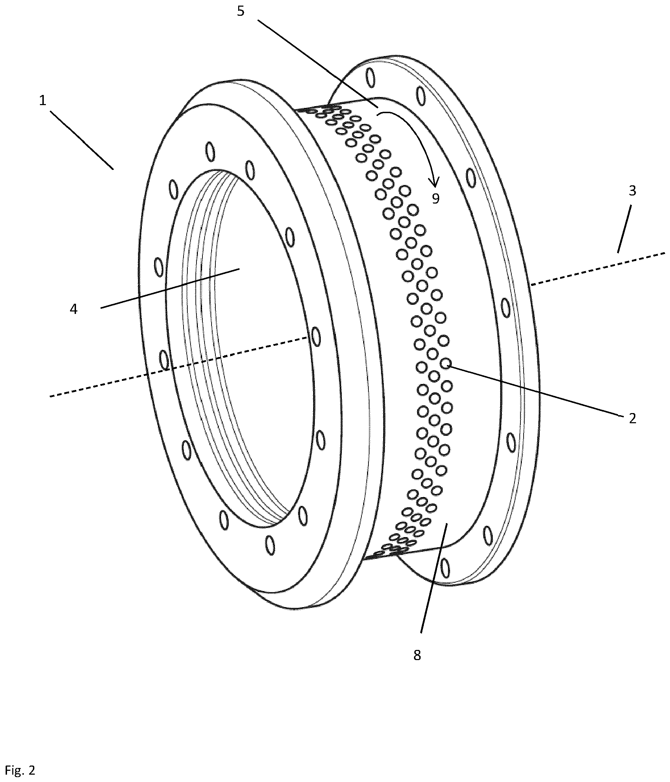

Fig. 2 shows a die according to the prior art, which die is configured as a ring die. Flat dies (not shown in Fig. 2) are also well known in the art. Such die 1 is suited for use in a pellet mill for producing pellets from a material. The die 1 comprises openings 2, the die 1 being rotatable around an axis of rotation 3, where the die 1 is configured for the material to be pressed from a radial inside 4 of the die 1 through the openings 2 to a radial outside 5 of the die 1. The die 1 shown in Fig. 2 is a cylindrical ring die, where the openings 2 connect the radial inside 4 of the die 1 with the radial outside 5 of the die 1 through the ring 8. The openings 2 being arranged in a circumferential direction 9 of the die 1.

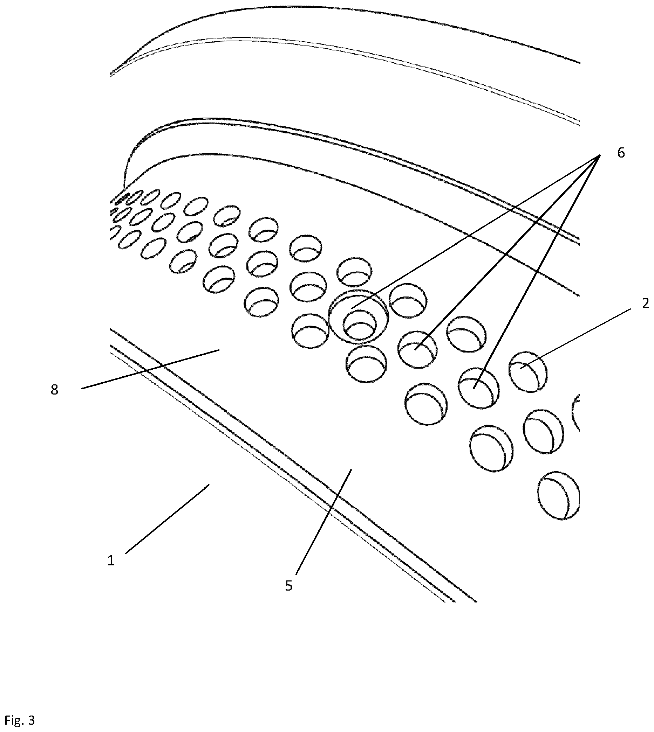

Fig. 3 shows a die according to the invention, which die is configured as a ring die. The die 1 shown in Fig. 3 is made of a ferromagnetic material and comprises openings 2 and die identification means 6 for inducing changes to a magnetic field of a sensor 7 providing the magnetic field, where the die identification means 6 consist of identification openings and the die identification means 6 being configured for allowing identification of the die 1. The openings 2 and the die identification means 6 configured as identification openings connect the radial inside 4 of the die 1 with the radial outside 5 of the die 1 through the ring 8. The die identification means 6 are configured as cylindrical holes and chamfered cylindrical holes, i.e. the die identification means 6 have a varying geometry and varying void volumes. Further the die identification means 6 are equally spaced in the circumferential direction 9 on the ring 8. The die 1 is devoid of permanent magnets for allowing identification of the die 1.

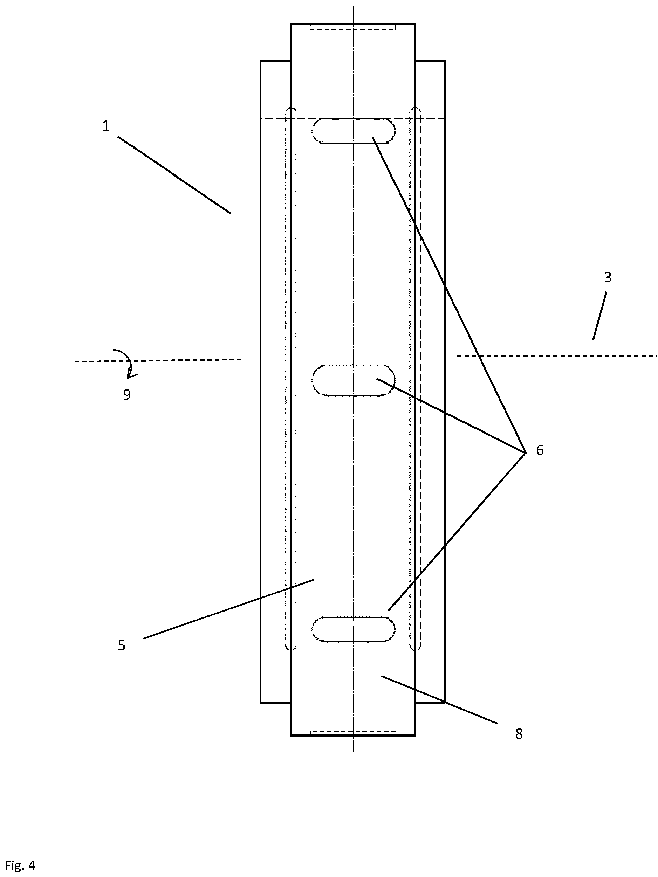

Fig. 4 shows a die according to the invention, which die is configured as a ring die and where only the identification means are shown. The die 1 is rotatable around an axis of rotation 3, and is made of a ferromagnetic material and comprises openings 2 (not shown) and die identification means 6 for inducing changes to a magnetic field of a sensor 7 providing the magnetic field, where the die identification means 6 consist of identification pockets and the die identification means 6 being configured for allowing identification of the die 1. The die identification means 6 configured as identification pockets are located on the radial outside 5 of the die 1. The die identification means 6 have varying void volumes. In Fig.4 the die identification mean 6 shown in the center has a higher void volume than the die identification means 6 shown above / below. The die identification means 6 are equally spaced in circumferential direction 9 on the ring 8. Again the die 1 is devoid of permanent magnets for allowing identification of the die 1.

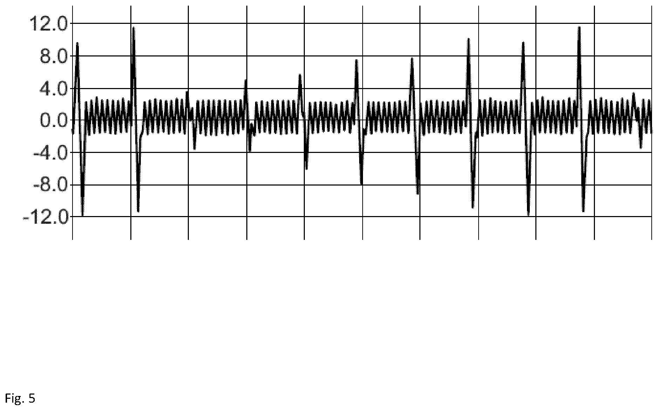

Fig. 5 shows a signal as received from a die identification system according to the invention with identification means with varying void volumes. Such die identification system comprises a die 1 and a sensor 7 (not shown), the sensor 7 providing a magnetic field, the die 1 and the sensor 7 being configured to be rotatable relative to each other and around the axis of rotation 3 for allowing a relative rotational movement of the die 1 and the magnetic field of the sensor 7 for inducing changes to the magnetic field via the die identification means 6 with varying void volumes and the sensor 7 being configured for detecting changes to the magnetic field. When the die comprising the die identification means inducing changes to the magnetic field as the die identification means rotate relative to an through the magnetic field of the sensor, the varying void volumes of the die identification means induce changes to the magnetic field at varying extent and make up for a signal as shown in Fig. 5, where the peaks of the signal need to be considered. Between the peaks some noise occurs, which can be ignored. Due to the equal spacing of the identification means 6 the peaks of the signal occur in equally spaced time steps, where the time is shown on the abscissa of Fig. 5. As the identification means provide varying void volumes, consequently varying changes to the magnetic field of the sensor 7 are induced at explicit levels, giving explicit peaks of the signal. On the left side of Fig. 5 high peaks of the signal are shown, which correspond with high void volumes, i.e. the higher the void volume of the identification mean 6, the higher the peak in the signal. Right to the two high peaks, a sequence of growing peaks can be seen, which corresponds to a sequence of identification means 6 with growing void volumes. The signal shown in Fig. 5 corresponds to the detected changes to the magnetic field, where the sensor typically gives as an output an electrical property. Such signal can easily be evaluated for identification. From Fig. 5 it is also clear that such die identification system with identification means with varying void volumes allows easy implementation of a number system with different digits, where the single identification mean 6 has an explicit void volume corresponding to a "number" of the number system. The explicit numbers of the single identification means will then allow for identification of the die.

The present invention offers numerous advantages and allows a reliable and effective identification of a die in operation in the pellet mill. The die identification according the inventions is robust, i.e. the harsh and demanding environment of pellet mill operation can be handled well. Especially there is no risk of losing any identification means during operation. The identification means can be manufactured easily and economically, where the die identification system can easily be retrofitted.

### Reference numbers

- 1: die
- 2: openings
- 3: axis of rotation
- 4: inside
- 5: outside
- 6: die identification means
- 7: sensor
- 8: ring
- 9: circumferential direction
- 10: pellet chamber
- 11: pellet mill
- 12: inlet
- 13: feeding means
- 14: conditioning means

## Claims

1. Die (1) for a pellet mill for producing pellets from a material, comprising openings (2), where the die (1) is configured for the material to be pressed from an inside (4) of the die (1) through the openings (2) to an outside (5) of the die (1), **characterized in that** the die (1) is made of a ferromagnetic material and the die (1) comprises die identification means (6) for inducing changes to a magnetic field of a sensor (7) providing the magnetic field, where the die identification means (6) consist of identification openings and / or identification pockets and the die identification means (6) being configured for allowing identification of the die (1).

2. Die (1) according to claim 1, where the die identification means (6) have varying void volumes.

3. Die (1) according to one of the claims 1 to 2, where the die identification means (6), especially the identification openings, have a varying geometry, such as cylindrical, chamfered cylindrical, conical, truncated cone, etc.

4. Die (1) according to one of the claims 1 to 3, where some of the die identification means (6) have no void volume.

5. Die (1) according to one of the claims 1 to 4, where the die (1) is devoid of permanent magnets for allowing identification of the die (1).

6. Die (1) according to one of the claims 1 to 5, where the die identification means (6) are configured as holes or slots.

7. Die (1) according to one of the claims 1 to 6, where the die identification means (6) configured as identification pockets are located on the outside (5) of the die (1).

8. Die (1) according to one of the claims 1 to 7, where the die (1) is a cylindrical ring die, the die (1) being rotatable around an axis of rotation (3), the inside (4) being configured as a radial inside and the outside (5) being configured as a radial outside, the openings (2) and the die identification means (6) configured as identification openings connect the radial inside (4) of the die (1) with the radial outside (5) of the die (1) through the ring (8).

9. Die (1) according to one of the claims 1 to 7, where the die (1) is a flat die, the die (1) being configured for the material to be pressed in an axial direction through the openings (2) of the die (1), the openings (2) and the die identification means (6) configured as identification openings connecting the inside (4) of the die (1) with the outside (5) of the die (1).

10. Die (1) according to one of the claims 1 to 9, where the die identification means (6) are arranged in a circumferential direction (9) of the die (1).

11. Die (1) according to claim 10, where the die identification means (6) are equally spaced in the circumferential direction (9).

12. Die identification system comprising a die (1) according to one of the claims 1 to 11 and a sensor (7), preferably a Hall sensor, an inductive sensor or similar, the sensor (7) providing a magnetic field, the die (1) and the sensor (7) being configured to be rotatable relative to each other around an axis of rotation (3) for allowing a relative rotational movement of the die (1) and the magnetic field of the sensor (7) for inducing changes to the magnetic field via the die identification means (6) and the sensor (7) being configured for detecting changes to the magnetic field.

13. Pellet chamber (10) for a pellet mill for producing pellets from a material comprising the die identification system according to claim 12, at least one extrusion mean being disposed on the inside (4) of the die (1), where the at least one extrusion mean is configured to press the material from the inside (4) of the die (1) through the openings (2) to the outside (5) of the die (1), knives for cutting off the material, said knives being disposed on the outside (5) of the die (1), where the sensor (7) is disposed at the outside (5) of the die (1) and the sensor (7) is configured to provide a magnetic field and to detect changes to the magnetic field induced by the die identification means (6) and thereby allowing die identification.

14. Pellet mill (11) for producing pellets from a material, comprising an inlet (12), feeding means (13), optional conditioning means (14) and a pellet chamber (10) according to claim 13, the feeding means (13) being configured to feed the material from the inlet (12) to the optional conditioning means (14) or to the pellet chamber (10), the optional conditioning means (14) being configured to feed the material to the pellet chamber (10).

15. Method for die identification in a pellet chamber (10), where the pellet chamber (10) according to claim 13 is provided with the die identification system according to claim 12, the die (1) and the magnetic field of the sensor (7) being in relative rotational movement around the axis of rotation (3), the sensor (7) providing the magnetic field, the die (1) comprising the die identification means (6) inducing changes to the magnetic field as the die identification means (6) rotate relative to and through the magnetic field provided by the sensor (7), the sensor (7) detecting for changes to the magnetic field and providing a signal for identification of the die (1), where the die identification means (6) optionally have varying void volumes.
